# DEMANDE DE BREVET EUROPEEN

(11) **EP 4 095 959 A1**
(43) Date de publication de la demande: **30.11.2022**
(21) Numéro de dépôt: 22175189.4
(22) Date de dépôt: 24.05.2022
(51) Int. Cl.: H01M 8/04537, G01R 1/067, G01R 31/396, H01R 13/642

(54) **DISPOSITIF DE MESURE DE TENSION POUR LA MESURE DE LA TENSION D'UNE PLURALITÉ DE CELLULES ÉLECTROCHIMIQUES D'UN RÉACTEUR ÉLECTROCHIMIQUE**

(30) Priorité: 26.05.2021 FR 2105461
(71) Demandeur: Alstom Hydrogène SAS, 13547 Aix en Provence Cedex 4 (FR)
(72) Inventeur: GRAND, Pierrick, 13290 LES MILLES (FR)
(74) Mandataire: Lavoix

(57) **Abrégé**

Le dispositif de mesure de tension est configuré pour la mesure de la tension d'une pluralité de cellules électrochimiques (20) d'un réacteur électrochimique formé d'un empilement de séparateurs (6) et d'assemblages membrane-électrodes (8), chaque cellule électrochimique (10) étant formée d'un assemblage membrane-électrodes (8) intercalé entre deux séparateurs (6), le dispositif de mesure de tension comprenant un support (22) possédant une base (24) et pluralité de dents (26) s'étendant à partir de la base (24) suivant une direction d'extension (D) commune, chaque dent (26) possédant une extrémité proximale (26A) reliée à la base (24) et une extrémité distale (26B) libre portant un contact électrique (28) prévu venir en contact avec un séparateur, le support comprenant des dents (26) dont les extrémités distales sont décalées les unes par rapport aux autres suivant la direction d'extension (D).

## Description

La présente invention concerne le domaine des réacteurs électrochimiques comprenant un empilement de séparateurs et d'assemblages membrane-électrodes définissant des cellules électrochimiques.

Un tel réacteur électrochimique est par exemple une pile à combustible pour la production d'électricité par réaction électrochimique entre un comburant et un combustible, ou un électrolyseur pour la séparation d'éléments chimiques d'un fluide en utilisant de l'électricité, par exemple pour la production de dihydrogène et de dioxygène à partir d'eau.

Dans un tel réacteur électrochimique, chaque assemblage membrane-électrodes se présente sous la forme d'un stratifié comprenant une membrane échangeuse d'ions insérée entre deux électrodes.

Chaque séparateur présente la forme d'une plaque, une ou chacune des deux faces du séparateur étant configurée pour être appliquée contre une face d'un assemblage membrane-électrodes en définissant avec cette face de l'assemblage membrane-électrode une chambre fluidique pour la circulation d'un fluide le long de ladite face de l'assemblage membrane-électrodes.

Chaque cellule électrochimique est définie par un assemblage membrane-électrodes compris entre deux séparateurs, chacun des séparateurs définissant une chambre fluidique avec la face de l'assemblage membrane-électrodes contre laquelle il est appliqué, la réaction électrochimique étant réalisée par échange d'ions entre des fluides circulant dans les chambres fluidiques, au travers de l'assemblage membrane-électrodes.

Il est possible de prévoir des séparateurs bipolaires, chaque séparateur bipolaire étant interposé entre deux assemblages membrane-électrodes, chacune des deux faces de chaque séparateur bipolaire étant configurée pour être appliquée contre une face d'un assemblage membrane-électrodes respectif, en définissant une chambre fluidique avec celui-ci.

Un réacteur électrochimique comprend par exemple un empilement alterné de séparateurs bipolaires et d'assemblages membrane-électrodes, deux séparateurs d'extrémité étant ajoutés aux extrémités de l'empilement pour compléter les deux cellules électrochimiques situées aux extrémités de l'empilement.

Au cours du fonctionnement du réacteur électrochimique, il est souhaitable de surveiller la tension électrique d'une ou plusieurs cellules électrochimiques, par exemple pour vérifier que la tension électrique de cette cellule électrochimique ou de ces cellules électrochimiques reste(nt) dans une plage de tension approprié, et ainsi prévenir un défaut ou une dégradation du réacteur électrochimique.

En pratique, un réacteur électrochimique formé d'un empilement de séparateurs et d'assemblages membrane-électrodes peut comprendre plusieurs dizaines ou plusieurs centaines de cellules électrochimiques. En outre, les séparateurs et les assemblages membrane-électrodes présentent des épaisseurs faibles. Ainsi, le raccordement de chaque cellule électrochimique à un appareil de mesure peut s'avérer fastidieux.

En outre, les cellules électrochimiques d'un tel empilement peuvent présenter une variabilité dans leur écartement, leur épaisseur et leur positionnement, ce qui complique la conception d'une connectique permettant de raccorder des cellules électrochimiques à un appareil électronique de mesure.

WO2014060727A1 divulgue un dispositif de connexion pour la connexion électrique de séparateurs à un appareil électronique de mesure, le dispositif de connexion comprenant un support en forme de peigne possédant des dents portant chacune un contact électrique, le support étant prévu de telle manière que chaque contact électrique puisse venir en contact électrique avec une zone de contact d'un séparateur.

Un des buts de l'invention est de proposer un dispositif de mesure pour la mesure de la tension de cellules électrochimiques, le dispositif de mesure devant être simple et rapide à mettre en oeuvre.

A cet effet, l'invention propose un dispositif de mesure de tension pour la mesure de la tension d'une pluralité de cellules électrochimiques d'un réacteur électrochimique formé d'un empilement de séparateurs et d'assemblages membrane-électrodes, chaque cellule électrochimique étant formée d'un assemblage membrane-électrodes intercalé entre deux séparateurs, le dispositif de mesure de tension comprenant un support possédant une base et une pluralité de dents s'étendant à partir de la base suivant une direction d'extension commune, chaque dent possédant une extrémité proximale reliée à la base et une extrémité distale libre portant un contact électrique prévu pour venir en contact avec un séparateur, le support comprenant des dents dont les extrémités distales sont décalées les unes par rapport aux autres suivant la direction d'extension.

Les contacts électriques portés par des dents d'un support ayant leurs extrémités distales décalées suivant la direction d'extension des dents facilitent le montage du dispositif de mesure de tension sur une face latérale de l'empilement, en s'assurant que le contact électrique porté par chaque dent puisse être mis en contact avec un séparateur respectif sans être gêné ou sans interférer avec un ou des dent(s) adjacente(s).

Cela facilite également le mouvement relatif des dents par flexion de ces dernières pour tenir compte, au montage, d'une variabilité de l'écartement, de l'épaisseur et/ou du positionnement des séparateurs, ainsi que, au cours du fonctionnement du réacteur électrochimique, d'une dilatation thermique ou d'une contraction thermique de l'empilement.

Selon des modes de réalisation particuliers, le dispositif de mesure de tension comprend une ou plusieurs des caractéristiques optionnelles suivantes, prises individuellement ou selon toutes les combinaisons techniquement possibles :
- les dents incluent des dents dont les extrémités distales sont alignées suivant un premier axe d'alignement et des dents dont les extrémités distales sont décalées par rapport au premier axe d'alignement ;
- le premier axe d'alignement est perpendiculaire à la direction d'extension ;
- le support comprend une rangée de dents dans laquelle alternent les dents dont les extrémités distales sont alignées suivant un premier axe d'alignement et des dents dont les extrémités distales sont décalées par rapport au premier axe d'alignement ;
- les dents dont les extrémités distales sont décalées par rapport au premier axe d'alignement ont leurs extrémités distales alignées suivant un deuxième axe d'alignement distinct du premier axe d'alignement ;
- le deuxième axe d'alignement est perpendiculaire à la direction d'extension et/ou parallèle au premier axe d'alignement ;
- les dents incluent des dents de différentes longueurs ;
- il comprend des dents présentant une première longueur et des dents présentant une deuxième longueur, la première longueur étant strictement supérieure à la deuxième longueur ;
- le support comprend une rangée de dents dans laquelle alternent des dents présentant la première longueur et des dents présentant la deuxième longueur ;
- les dents sont réparties entre une première rangée de dents et une deuxième rangée de dents situées de part et d'autre de la base ;
- au moins une dent ou chaque dent présente une largeur progressivement décroissante puis croissante depuis l'extrémité proximale de la dent vers l'extrémité distale de la dent ;
- le support comprend une rangée de dents ayant une première dent portant un contact électrique supplémentaire configuré pour venir en contact avec un séparateur adjacent à celui avec lequel le contact électrique porté par cette première dent vient en contact ;
- il comprend une unité électronique de mesure, chaque contact électrique étant relié à l'unité électronique de mesure, l'unité électronique de mesure étant configurée pour générer un signal de mesure de tension respectif pour chaque cellule électrochimique dont la tension est prise grâce au dispositif de mesure de tension, à partir de signaux électriques fournis par les contacts électriques et/ou pour conditionner les signaux électriques fournis par les contacts électriques et/ou des signaux de mesure de tension générés par l'unité électronique de mesure, pour leur transmission à un appareil électronique ;
- il comprend un connecteur pour connecter le dispositif de mesure de tension à un appareil électronique.

L'invention concerne également un système électrochimique comprenant un réacteur électrochimique formé d'un empilement de séparateurs et d'assemblages membrane-électrodes définissant des cellules électrochimiques, chaque cellule électrochimique étant formée d'un assemblage membrane-électrodes intercalé entre deux séparateurs, et au moins un dispositif de mesure de tension tel que défini ci-dessus.

L'invention et ses avantages seront mieux compris à la lecture de la description qui va suivre, donnée uniquement à titre d'exemple non limitatif, et faite en référence aux dessins annexés, sur lesquels :
- la Figure 1 est une vue de côté d'un réacteur électrochimique formé d'un empilement de séparateurs et d'assemblages membrane-électrodes, équipé de dispositifs de mesure de tension ;
- la Figure 2 est vue en coupe du réacteur électrochimique, illustrant une cellule électrochimique formée d'un assemblage membrane-électrodes interposé entre deux séparateurs bipolaires;
- la Figure 3 est une vue de face d'un dispositif de mesure de tension ;
- la Figure 4 est une vue en coupe d'un contact électrique du dispositif de mesure de tension en contact avec un séparateur ;
- la Figure 5 est une vue agrandie de la zone V sur la Figure 1, illustrant deux dispositifs de mesure de tension disposés côte à côte sur le réacteur électrochimique ; et
- la Figure 6 est une vue de face d'un dispositif de mesure de tension.

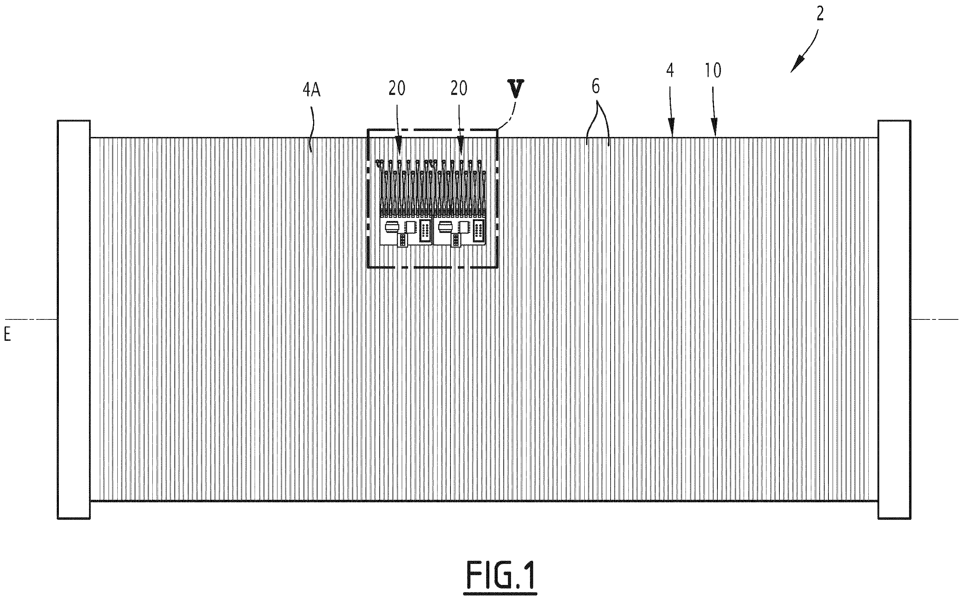

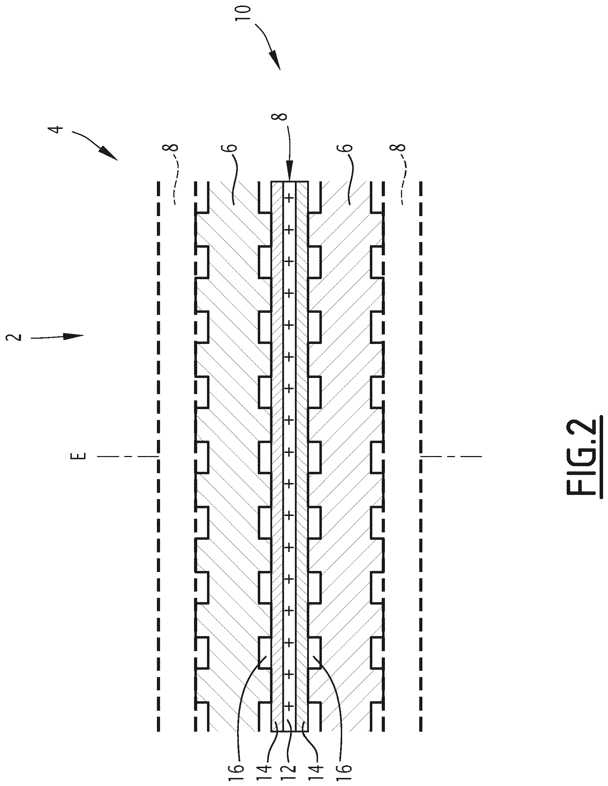

Le réacteur électrochimique 2 illustré sur les Figures 1 et 2 possède un empilement 4 (ou « stack ») de séparateurs 6 et d'assemblages membrane-électrodes 8 (Figure 2) définissant une pluralité de cellules électrochimiques 10 superposées.

Les séparateurs 6 et les assemblages membrane-électrodes 8 sont empilés suivant une direction d'empilement E. Les cellules électrochimiques 10 sont superposées suivant la direction d'empilement E.

En pratique, un réacteur électrochimique 2 peut comprendre plusieurs dizaines ou centaines de cellules électrochimique 10 superposées.

Comme illustré sur la Figure 2, dans l'empilement 4, chaque cellule électrochimique 10 est formée par un assemblage membrane-électrodes 8 interposé entre deux séparateurs 6.

L'assemblage membrane-électrodes 8 se présente sous la forme d'un stratifié formé d'une membrane échangeuse d'ions 12 interposée entre deux électrodes 14. La membrane échangeuse d'ions 12 est par exemple une membrane échangeuse de protons (ou PEM de l'anglais « Proton Exchange Membrane »).

Chaque séparateur 6 se présente sous la forme d'une plaque.

Dans chaque cellule électrochimique 10, chaque séparateur 6 est appliqué contre une face respective de l'assemblage membrane-électrodes 8.

Chacun des deux séparateurs 6 de la cellule électrochimique 10 a sa face appliquée contre l'assemblage membrane-électrodes 8 qui est configurée pour canaliser un fluide le long de la face de l'assemblage membrane-électrodes 8 contre laquelle le séparateur 6 est appliqué.

La face du séparateur 6 appliquée contre l'assemblage membrane-électrodes 8 définit avec celui-ci une chambre fluidique pour la circulation du fluide. Elle comprend par exemple des canaux de distribution 16 pour la circulation du fluide. Les canaux de distribution 16 définissent ensemble la chambre fluidique.

En fonctionnement, dans chaque cellule électrochimique 10, les fluides circulant le long des deux faces opposées de l'assemblage membrane-électrodes 8 permettent la réalisation d'une réaction électrochimique avec échange d'ions entre les fluides canalisés par les deux séparateurs 6 situés de part et d'autre de l'assemblage membrane-électrodes 8, les ions passant à travers l'assemblage membrane-électrode 8.

Si le réacteur électrochimique 2 est une pile à combustible, un des deux séparateurs 6 est configuré pour canaliser un fluide combustible le long de la face de l'assemblage membrane-électrodes 8 contre laquelle il est appliqué, l'autre séparateur 6 étant configuré pour canaliser un fluide comburant le long de l'autre face de l'assemblage membrane-électrodes 8 contre laquelle il est appliqué.

L'empilement 4 comprend par exemple des séparateurs 6 bipolaires, chaque séparateur 6 bipolaire étant interposé entre deux assemblage membrane-électrodes 8, chacune des deux faces du séparateur 6 étant configuré pour canaliser un fluide le long de la face de l'assemblage membrane-électrode 8 contre laquelle cette face du séparateur 6 est appliquée. Chaque séparateur 6 bipolaire est commun à deux cellules électrochimiques 10 adjacentes.

L'empilement 4 comprend par exemple des séparateurs 6 monopolaires, chaque séparateur 6 monopolaire ayant une seule de ses deux faces appliquée contre une face d'un assemblage membrane-électrodes 8, cette face du séparateur 6 étant configurée pour canaliser un fluide le long de ladite face de l'assemblage membrane-électrode 8. Chaque séparateur 6 monopolaire est appartient à une seul cellule électrochimique 10.

L'empilement 4 est par exemple formé de séparateurs 6 bipolaires empilés en alternance avec des assemblages membrane-électrodes 8, deux séparateurs 6 monopolaires étant disposés aux extrémités de l'empilement 4 pour définir les deux cellules électrochimiques 10 situées aux extrémités de l'empilement 4.

Chaque séparateur 6 est réalisé dans un matériaux conducteur d'électricité. Chaque séparateur 6 est par exemple formé dans un matériau métallique, un matériau à base de graphite ou de composite graphite-polymère.

Dans l'empilement 4 du réacteur électrochimique 2, les cellules électrochimiques 10 sont reliées électriquement en série. Chaque cellule électrochimique 10 est reliée électriquement à la cellule électrochimique 10 suivante.

En fonctionnement, chaque cellule électrochimique 10 présente une tension électrique qui correspond à la différence de potentiel électrique entre les deux séparateurs 6 de cette cellule électrochimique 10.

Le réacteur électrochimique 2 est équipé d'au moins un dispositif de mesure de tension 20, chaque dispositif de mesure de tension 20 étant configuré pour la mesure de la tension d'une pluralité de cellules électrochimiques 10 adjacentes de l'empilement 4.

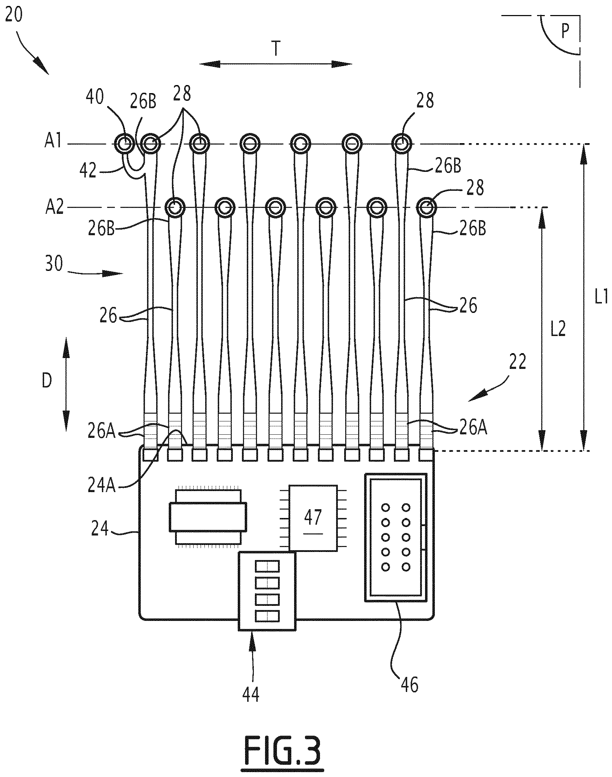

Tel qu'illustré sur la Figure 1, le réacteur électrochimique 2 est équipé de deux dispositifs de mesure de tension 20 analogues. Seul un dispositif de mesure de tension 20 sera décrit plus en détail en référence à la Figure 3.

Comme illustré sur cette Figure 3, le dispositif de mesure de tension 20 comprend un support 22 possédant une base 24 et une pluralité de dents 26 s'étendant à partir de la base 24 suivant une direction d'extension D. Les dents 26 s'étendent parallèlement entre elles.

Chaque dent 26 possède une extrémité proximale 26A reliée à la base 24 et une extrémité distale 26B portant un contact électrique 28. Chaque dent 26 porte un contact électrique 28 respectif.

Le contact électrique 28 porté par chaque dent 26 est de préférence situé à l'extrémité distale 26B de cette dent 26.

Chaque dent 26 est de préférence munie d'un seul contact électrique 28 disposé sur la dent 26, en particulier sur son extrémité distale 26B, chaque contact électrique 28 étant prévu pour venir en contact avec un séparateur 6 respectif de l'empilement 4.

Le support 22 comprend des dents 26 disposées côte à côte formant une rangée 30 de dents 26. Les dents 26 formant une rangée 30 s'étendent suivant la direction d'extension D à partir d'un bord 24A de la base 24.

Le support 22 est configuré pour que les contacts électriques 28 puissent être mise en contact avec les séparateurs 6 des cellules électrochimiques 10 dont la tension est mesurée à l'aide du dispositif de mesure de tension 20.

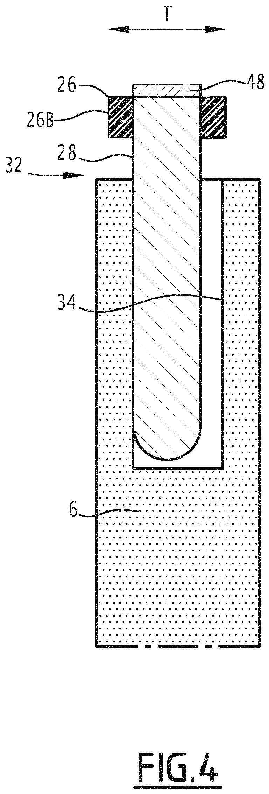

Comme illustré sur la Figure 4 représentant une extrémité distale 26B d'une dent 26 portant un contact électrique 28, le support 22 est configuré de telle manière que chaque contact électrique 28 vienne en contact avec une zone de contact 32 d'un séparateur 6 respectif parmi les séparateurs 6 des cellules électrochimiques 10 dont la tension est mesurée à l'aide du dispositif de mesure de tension 20.

La zone de contact 32 de chaque séparateur 4 est par exemple située sur une face latérale 4A de l'empilement 4.

En particulier, de manière avantageuse, la zone de contact 32 de chaque séparateur 6 est située sur un bord périphérique du séparateur 6, la zone de contact 32 étant exposée sur la face latérale 4A de l'empilement 4.

Ainsi, le dispositif de mesure de tension 20 peut être monté sur la face latérale 4A de l'empilement 4 de manière à mettre les contact électriques 28 en contact avec les séparateurs 4 des cellules électrochimiques 10 dont la tension est mesurée à l'aide du dispositif de mesure de tension 20.

Avantageusement, chaque contact électrique 28 se présente sous la forme d'un pion de contact, la zone de contact 32 de chaque séparateur 6 présentant un orifice 34 configuré pour recevoir le contact électrique 28, ce dernier étant inséré dans l'orifice 34. Lorsque le dispositif de mesure de tension 20 est monté sur l'empilement 4, chaque contact électrique 28 s'insère dans un orifice 34 d'un séparateur 6 respectif.

En revenant à la Figure 3, de préférence, les dents 26 s'étendent dans un plan d'extension P commun (plan de la Figure 3). Le plan d'extension P contient la direction d'extension D et une direction transversale T perpendiculaire à la direction d'extension D.

De préférence, le dispositif de mesure de tension 20 est configuré pour être monté sur une face latérale 4A de l'empilement 4 de sorte que la direction d'extension D des dents 26 est perpendiculaire à la direction d'empilement E. La direction transversale T est parallèle à la direction d'empilement E.

Chaque dent 26 s'étend parallèlement au bord d'un séparateur 6 respectif, plus particulièrement le long du bord du séparateur 6 avec lequel le contact électrique 28 porté par cette dent 26 est en contact.

Les dents 26 sont espacées transversalement les unes des autres de manière que le dispositif de mesure de tension 20 puisse être monté sur l'empilement 4 avec chaque dent 26 située en regard d'une séparateur 6 respectif.

Dans un exemple de réalisation, l'espacement transversal entre deux dents 24 successives d'une rangée 30 de dents 24 correspond à l'écartement entre deux séparateurs 6 successifs de l'empilement 4.

Avantageusement, chaque dent 26 est configurée pour fléchir latéralement de manière élastique. La flexion latérale d'une dent 26 se fait dans le plan d'extension P. La flexion latérale de chaque dent 26 entraîne un déplacement du contact électrique 28 porté par cette dent 26 suivant la direction transversale T.

La flexion latérale des dents 26 permet de compenser la variabilité de positionnement des séparateurs 6 et/ou des orifices 34 des zones de contact 32 des séparateurs 6, ainsi que d'éventuels déplacement relatifs des zones de contact 32 dus par exemple à une dilatation ou une contraction thermique de l'empilement 4, en particulier au cours du fonctionnement du réacteur électrochimique 2.

Dans un exemple de réalisation, chaque dent 26 présente une largeur qui diminue progressivement puis augmente progressivement depuis l'extrémité proximale 26A de la dent 26 vers l'extrémité distale 26B de la dent 26. Chaque dent 26 est moins large dans une zone intermédiaire de la dent 26 qu'à son extrémité distale 26A et qu'à son extrémité proximale 26B. La largeur de chaque dent 26 est prise suivant la direction transversale T.

Ceci permet de conférer une flexibilité latérale à la dent 26 tout en assurant une liaison fiable avec la base 24 et une liaison fiable avec le contact électrique 28 porté par l'extrémité distale 26A de la dent 26.

Le support 22 comprend des dents 26 dont les extrémités distales 26A sont décalées les unes par rapport aux autres suivant la direction d'extension D.

Ceci facilite le montage du dispositif de mesure de tension 20 sur l'empilement 4 en permettant de positionner le contact électrique 28 porté par chaque dent 26 en étant moins gêné par des dents 26 adjacentes.

Dans un exemple de réalisation, comme illustré sur la Figure 3, une rangée 30 de dents 26 disposées côte à côte inclut des dents 26 ayant leurs extrémités distales 26A décalées les unes par rapport aux autres suivant la direction d'extension D.

Avantageusement, chaque dent 26 de la rangée 30 a son extrémité distale 26B décalée suivant la direction d'extension D par rapport à l'extrémité distale 26B de chaque dent 26 adjacente de la rangée 30.

En particulier, chaque dent 26 de la rangée 30 située entre deux autres dents 26 adjacentes de la rangée 30 a son extrémité distale 26B décalée suivant la direction d'extension D par rapport aux extrémités distales 32B des deux autres dents 26 adjacentes de la rangée 30.

Dans un exemple de réalisation, le support 22 comprend des dents 26 dont les extrémités distales 26B sont alignées suivant un premier axe d'alignement A1 et d'autres dents 26 dont les extrémités distales 26B sont décalées par rapport au premier axe d'alignement A1.

En particulier, le support 22 comprend une rangée 30 de dents 26 disposées côté à côte incluant des dents 26, formant un premier groupe, dont les extrémités distales 26B sont alignées suivant un premier axe d'alignement A1 et des dents 26, formant un deuxième groupe, dont les extrémités distales 26B sont décalées par rapport au premier axe d'alignement A1.

Les dents 26 du premier groupe et les dents 26 du deuxième groupe sont par exemple disposées en alternance dans la rangée 30.

Ainsi, chaque dent 26 a son extrémité distale 26A décalée suivant la direction d'extension D par rapport à l'extrémité distale 26A de chaque dent 26 adjacente de la rangée 30.

Le premier axe d'alignement A1 est par exemple perpendiculaire à la direction d'extension D. Le premier axe d'alignement A1 est alors parallèle à la direction transversale T.

Dans un exemple de réalisation, les dents 26 du deuxième groupe ont leur extrémités distales 26B alignées suivant un deuxième axe d'alignement A2 distinct du premier axe d'alignement A1.

En particulier, le support 22 comprend une rangée 30 de dents 26 disposées côté à côte incluant des dents 26 dont les extrémités distales 26B sont alignées suivant un premier axe d'alignement A1 et des dents 26 dont les extrémités distales 26B sont alignées suivant un deuxième axe d'alignement A2 distinct du premier axe d'alignement A1.

Le support 22 comprend dans ce cas une rangée 30 de dents 26 comprenant un premier groupe des dents 26 dont les extrémités distales 26B sont alignées suivant le premier axe d'alignement A1 et un deuxième groupe de dents 26 dont les extrémités distales 26B sont alignées suivant un deuxième axe d'alignement A2 distinct du premier axe d'alignement A1.

Dans un exemple de réalisation particulier, le deuxième axe d'alignement A2 est perpendiculaire à la direction d'extension D et/ou parallèle au premier axe d'alignement A1.

Ainsi, dans l'exemple de réalisation particulier illustré sur la Figure 3, le support 22 comprend une rangée 30 formée d'un premier groupe de dents 26 dont les extrémités distales 26B sont alignées suivant le premier axe d'alignement A1 et un deuxième groupe de dents 26 dont les extrémités distales 26B sont alignées suivant un deuxième axe d'alignement A2 distinct du premier axe d'alignement A1, le premier axe d'alignement A1 et le deuxième axe d'alignement A2 étant tous les deux perpendiculaires à la direction d'extension D.

Dans un exemple de réalisation, les dents 26 du support 22 incluent des dents 26 de différentes longueurs.

Ceci permet de prévoir une rangée 30 de dents 26 partant d'un même bord 24A de la base 24 qui est sensiblement perpendiculaire à la direction d'extension D, les dents 26 ayant des extrémités distales 26B décalées suivant la direction d'extension D.

Dans un exemple de réalisation, le support 22 comprend des dents 26 présentant une première longueur L1 et des dents 26 présentant une deuxième longueur L2, la première longueur L1 étant strictement supérieure à la deuxième longueur L2.

Dans un exemple de réalisation particulier, le support 22 comprend une rangée 30 de dents 26 disposées côte à côte, incluant un premier groupe de dents 26 présentant une première longueur L1 et un deuxième groupe de dents 26 présentant une deuxième longueur L2, la première longueur L1 étant strictement supérieure à la deuxième longueur L2.

De préférence, les dents 26 du premier groupe et les dents 26 du deuxième groupe sont disposées en alternance dans la rangée 30.

Dans l'exemple de réalisation illustré sur la Figure 3, le support 22 comprend la rangée 30 formée de dents 26 présentant une première longueur L1 alternant avec des dents 26 présentant une deuxième longueur L2 strictement inférieure à la première longueur L1. Les dents 26 s'étendent à partir du bord 24A de la base 24, ce bord 24A étant sensiblement perpendiculaire à la direction d'extension D. Les extrémités distales 26B des dents 26 présentant la première longueur L1 sont alignées suivant le premier axe d'alignement A1 perpendiculaire à la direction d'extension D et les dents 26 présentant la deuxième longueur L2 sont alignés suivant le deuxième axe d'alignement A2 perpendiculaire à la direction d'extension D.

Une rangée 30 de dents 26 disposées côte à côte comprend, en se déplaçant d'une extrémité de la rangée 30 vers l'autre extrémité de la rangée 30, une première dent 26 et une dernière dent 26.

Optionnellement, le support 22 comprend une rangée 30 de dents 26 dont la première dent 26 porte un contact électrique supplémentaire 40 configuré pour venir en contact avec un séparateur 6 adjacent au séparateur 6 avec lequel est en contact le contact électrique 28 porté par ladite première dent 26.

Le contact électrique supplémentaire 40 est par exemple monté sur une extension 42 s'étendant en saillie latéralement à partir de la dent 26, du côté opposé à la deuxième dent 26 de la rangée 30 adjacente à la première dent 26.

L'extension 42 rejoint la première dent 26 à distance de l'extrémité proximale de cette première dent 26

Tel qu'illustré sur la Figure 3, la première dent 26 de la rangée 30 est celle située le plus à gauche et la dernière dent 26 de la rangée 30 est celle située le plus à droite. Bien entendu, la configuration pourrait être inversée.

Avantageusement, le dispositif de mesure de tension 20 est configuré pour être disposé à côté d'un autre dispositif de mesure de tension 20 de telle manière que les deux dispositif de mesure de tension 20 mesurent les tensions de deux groupes de cellules électrochimiques 10 adjacents, sans interférence mécanique entre les deux dispositifs de mesure de tension 20, en particulier sans interférence mécanique de l'extension 42 d'un des deux dispositifs de mesure de tension 20 avec l'autre dispositifs de mesure de tension 20.

Dans un exemple de réalisation, l'extrémité distale 26B de la première dent 26 est plus avancée suivant la direction d'extension D que l'extrémité distale 26B de la dernière dent 26. En particulier, l'extension 42 est plus avancée le long de la direction d'extension D que l'extrémité distale de la dernière dent 26.

Dans l'exemple de réalisation de la Figure 3, la première dent 26 de la rangée 30 présente une première longueur L1, et la dernière dent 26 de la rangée (située à l'extrémité droite de la rangée 30) présente une deuxième longueur L2 strictement inférieure à la première longueur L1. L'extension 42 rejoint la première dent 26 à une distance de l'extrémité proximale 26A de ladite première dent 26 qui est strictement supérieure à la deuxième longueur L2.

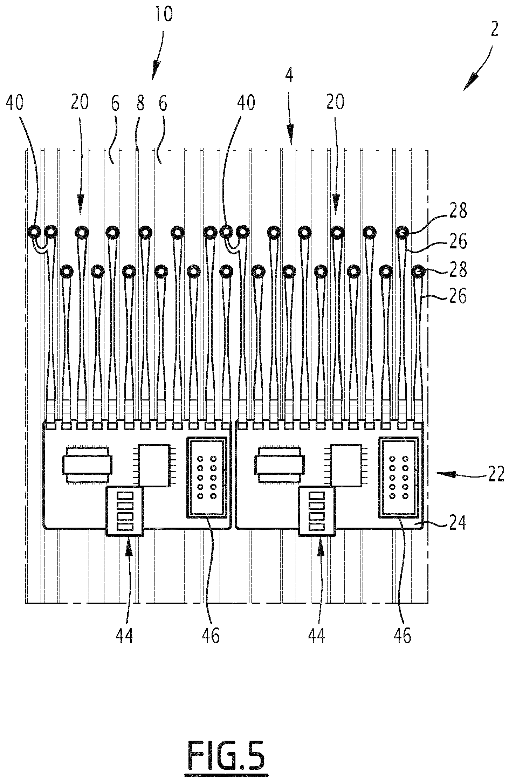

Comme illustré sur la Figure 5, il est possible de disposer le dispositif de mesure de tension 20 à côté d'un autre dispositif de mesure de tension 20, le contact électrique supplémentaire 40 porté par la première dent 26 de l'autre dispositif de mesure de tension 20 et le contact électrique 28 de la dernière dent 26 du dispositif de mesure de tension 20 étant tous les deux en contact avec le même séparateur 6 sans interférer l'un avec l'autre.

Dans un empilement 4 comprenant des séparateurs 6 bipolaires, deux dispositifs de mesure de tension 20 ainsi disposés côte à côte peuvent mesurer les tensions électriques des cellules électrochimiques 10 de deux groupes de cellules électrochimiques 10 adjacents, le contact électrique supplémentaire 40 permettant de mesurer la tension de la cellule électrochimique 10 située à l'interface entre les deux groupes de cellules électrochimiques 10 adjacents.

De tels dispositif de mesure de tension 20 peuvent ainsi être disposés côte à côte le long de l'empilement 4 de manière modulaire, en disposant autant de dispositif de mesure de tension 20 que nécessaire pour mesurer les tensions électriques d'un nombre de cellules électrochimiques 10 adjacentes souhaité.

En pratique, il n'est pas nécessaire de mesurer la tension de toutes les cellules électrochimiques 10 de l'empilement 4.

Il est par exemple possible de mesurer la tension de cellules électrochimiques 10 dans un premier tronçon de l'empilement 4, à l'aide d'un dispositif de mesure de tension 20 ou de plusieurs dispositifs de mesure de tension 20 disposés côte à côte, de mesurer la tension de cellules électrochimiques 10 dans un deuxième tronçon de l'empilement 4, à l'aide d'un dispositif de mesure de tension 20 ou de plusieurs dispositifs de mesure de tension 20 disposés côte à côte, sans mesurer la tension dans un des cellules électrochimiques 10 situées dans un tronçon intermédiaire située entre le premier tronçon et le deuxième tronçon.

En option, le dispositif de mesure de tension 20 comprend une unité électronique de mesure 44 portée par la base 24 et un connecteur électrique 46 porté par la base 24.

Chaque contact électrique 28, et le cas échéant, le contact électrique supplémentaire 40, est relié électriquement à l'unité électronique de mesure 44.

La liaison électrique entre chaque contact électrique (contact électrique 28 ou contact électrique supplémentaire 40) et l'unité électronique de mesure 44 est effectué par exemple via une piste conductrice 48 (Figure 4) s'étendant le long de la dent 26 portant ce contact électrique.

L'unité électronique de mesure 44 est par exemple configurée pour traiter les signaux électriques récupérés par les contacts électriques 28 et générer des signaux de mesure correspondants.

L'unité électronique de mesure 44 est par exemple configurée pour la transmission des signaux de mesure à un appareil électronique via le connecteur électrique 46.

Les signaux électriques sont des signaux analogiques représentatifs du potentiel électrique de chaque contact électrique 28.

Les signaux de mesure sont des signaux analogiques ou, de préférence, des signaux numériques.

L'unité électronique de mesure 44 est par exemple configurée pour générer des signaux de mesure qui sont représentatifs de la tension de chaque cellule électrochimique 10 considérée, i.e. la différence de potentiel entre les deux séparateurs 6 de chaque cellule électrochimique 10.

Dans ce cas, l'unité électronique de mesure 44 réalise un traitement pour déterminer la tension de chaque cellule électrochimique 10 à partir des signaux électriques et générer un signal de mesure de tension correspondant.

En variante, l'unité électronique de mesure 44 est configurée pour conditionner les signaux électriques récupérés par les contacts électriques 28 en signaux de mesure numériques pour leur transmission à un appareil électronique via le connecteur électrique 46.

Dans ce cas, l'unité électronique de mesure 44 ne traite pas les signaux électriques pour générer les signaux de mesure de tension, mais se contente de conditionner les signaux électriques en signaux numériques pour les transmettre, la tension de chaque cellule électrochimique 10 considérée étant par exemple déterminée par l'appareil électronique à partir des signaux numériques reçus.

Dans les cas où l'unité électronique de mesure 44 est configurée pour générer des signaux de mesure numériques (avec ou sans traitement réalisé au sein de l'unité électronique de mesure 44 pour déterminer des mesure de tension) et les transmettre à un appareil électronique via le connecteur électrique 46, l'unité électronique de mesure 44 intègre de préférence un circuit d'isolation galvanique numérique 47 configuré pour isoler électriquement l'appareil électronique de l'unité électronique de mesure 44.

Le circuit d'isolation galvanique numérique 47 est par exemple configuré pour transmettre les informations entre l'unité électronique de mesure 44 et l'appareil électronique sous la forme de signaux lumineux (isolation optique) ou d'impulsions magnétique (isolation par transformateur d'impulsion) ou tout autre procédé d'isolation...

Le connecteur électrique 46 est alors isolé électriquement du reste du dispositif de mesure de tension 20.

Ceci représente un avantage car la tension à la terre d'une cellule électrochimique 10 d'un réacteur électrochimique peut être de plusieurs centaines de volts alors que les appareils électroniques qui exploitent les mesures de tension travaillent avec une tension à la terre de seulement quelques voltes. Une isolation galvanique au plus proche du réacteur électrochimique protège aussi l'utilisateur.

Par ailleurs, la transformation des signaux analogiques en signaux numériques au plus proche du réacteur électrochimique 2 évite la dégradation des signaux analogiques par la pollution électromagnétique de l'environnement, comparé au cas où les signaux analogiques seraient transmis à un appareil électronique sans numérisation préalable.

Avantageusement, l'unité électronique de mesure 44 est conçue de manière à s'interfacer sur un bus de communication numérique. En particulier, le connecteur électrique 46 est conçu de manière à s'interfacer sur un bus de communication numérique.

De cette manière, plusieurs dispositifs de mesure de tension 20 peuvent être connectés à un seul bus de communication numérique, chaque dispositif de mesure de tension 20 étant connecté au bus de communication numérique par le biais de son connecteur électrique 46. Le bus de communication numérique est relié à un appareil électronique chargé de récupérer et/ou exploiter les mesures de tensions. Ceci présente l'avantage de simplifier le câblage.

L'unité électronique de mesure 44 comprend par exemple un circuit intégré dédié (ou ASIC pour « Application Specific Integrated Circuit »). En complément ou en variante, l'unité électronique de mesure 44 comprend un circuit logique programmable ou une unité électronique de traitement de données incluant un mémoire et un processeur.

Avantageusement, le support 22 du dispositif de mesure de tension 20 est une plaque de circuit imprimé. Ainsi, le support 22 peut être formé simplement, par exemple par découpage d'une plaque de circuit imprimé pour former la base 24 et les dents 26. En variante, il peut être formée par fabrication additive (ou « impression 3D »).

Lorsque le support 22 est prévu sous la forme d'une plaque de circuit imprimé, l'unité électronique de mesure 44 peut être montée facilement sur le support 22, par exemple en fixant des composants électroniques de l'unité électronique de mesure 44 et en les reliant entre eux, par exemple à l'aide de piste électriques.

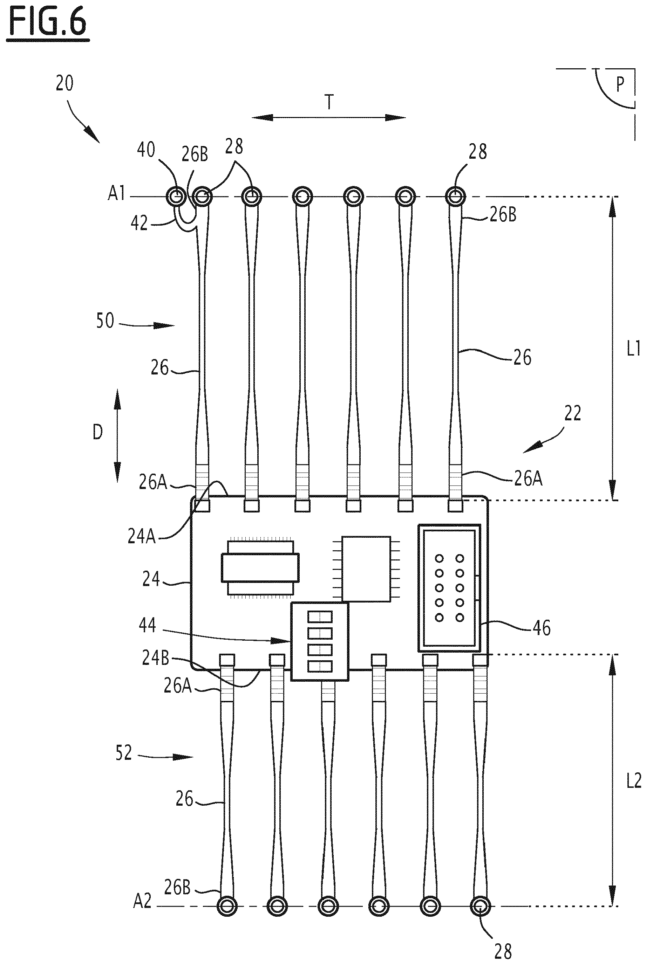

Le dispositif de mesure de tension 20 de la Figure 6 diffère de celui de la Figure 3 en ce que les dents 26 sont réparties en deux rangée de dents 26 situées de part et d'autre de la base 24.

Les deux rangées de dents 26 sont désignées par la suite première rangée 50 et deuxième rangée 52.

Les dents 26 des de la première rangée 50 et de la deuxième rangée 52 s'étendent à partir de la base 24 suivant la même direction d'extension D.

Les dents 26 de la première rangée 50 s'étendent à partir d'un bord 24A de la base 24 (ou « premier bord 24A ») et les dents 26 de la deuxième rangée 52 s'étendent à partir d'un autre bord 24B de la base 24 (ou « deuxième bord 24B ») opposé audit premier bord 24A.

Les dents 26 de la première rangée 50 et les dents 26 de la deuxième rangée 52 s'étendent en directions opposées à partir de la base 24.

Les extrémités distales des dents 26 de la première rangée 50, située d'un côté de la base 24, sont bien décalées le long de la direction d'extension D par rapport aux extrémités distales 26B des dents 26 de la deuxième rangée 52.

Comme illustré sur la Figure 6, les dents 26 de la première rangée 50 ont par exemple leur extrémités distales 26B alignées suivant un axe d'alignement A1.

Dans un exemple de réalisation particulier, l'axe d'alignement A1 des extrémités distales 26B des dents 26 de la première rangée 50 est perpendiculaire à la direction d'extension D.

Les dents 26 de la deuxième rangée 52 ont par exemple leurs extrémités distales 26B alignées suivant un axe d'alignement A2.

Dans un exemple de réalisation particulier, l'axe d'alignement A2 des extrémités distales 26B des dents 26 de la deuxième rangée 52 est perpendiculaire à la direction d'extension D.

Dans un exemple de réalisation, les dents 26 de la première rangée 50 présentent une même première longueur L1 et/ou les dents 26 de la deuxième rangée 52 présentent une même deuxième longueur L2.

Lorsque les dents 26 de la première rangée 50 présentent une même première longueur L1 et les dents 26 de la deuxième rangée 52 présentent une même deuxième longueur L2, la première longueur L1 et la deuxième longueur L2 sont par exemple égales.

En variante, une de la première longueur L1 et de la deuxième longueur L2 est strictement inférieure ou supérieure à l'autre.

De préférence, dans un mode de réalisation dans lequel les dents 26 forment une première rangée 50 et une deuxième rangée 52 situées de part et d'autre de la base 24, dans chacun de la première rangée 50 et de la deuxième rangée 52, l'écartement entre deux dents 24 successives de la rangée correspond au double de l'écartement entre deux séparateurs 6 successifs de l'empilement 4.

De préférence, dans un mode de réalisation dans lequel les dents 26 forment une première rangée 50 et une deuxième rangée 52 situées de part et d'autre de la base 24, les dents 26 de la première rangée 50 et les dents de la deuxième rangée 52 sont décalées transversalement, de sorte que chaque intervalle entre deux dents 26 d'une parmi la première rangée 50 et la deuxième rangée 52 est aligné suivant la direction d'extension D avec une dent 26 de l'autre parmi la première rangée 50 et la deuxième rangée.

Ainsi, dans l'empilement 4, des séparateurs 6 successifs des cellules électrochimiques 10 dont la tension est mesurée à l'aide du dispositif de mesure de tenson 20 sont mis en contact en alternance avec les contacts électriques 28 des dent 26 de la première rangée 50 et les contacts électriques 28 des dent 26 de la deuxième rangée 52.

Un dispositif de mesure de tension 20 tel que représenté sur la Figure 6 peut être mise à côté d'un autre dispositif de mesure de tension 20 analogue sans interférence de l'extension 42 portant le contact supplémentaire 20 avec l'autre dispositif de mesure de tension 20.

Grâce à l'invention, il est possible d'obtenir un dispositif de mesure de tension 20 permettant de mesurer la tension de plusieurs cellules électrochimiques 20 d'un empilement 4, le dispositif de mesure de tension 20 pouvant être installé de manière simple sur l'empilement 4.

En particulier, les dents 26 portant les contacts électriques 28 permettent de mettre chaque contact électrique 28 en contact avec un séparateur 6 de l'empilement. Les dents 26 flexibles latéralement permettent de tenir compte de variation de dimensions.

Les extrémités distales 26 portant les contacts électriques 28 qui sont décalés suivant la direction d'extension des dents 26 permet d'éviter que les extrémités distales 26B portant les contacts électriques 28 soient côte à côte.

Ceci facilite le montage en évitant des interférences entre les dents 26 et/ou en permettant un plus grand débattement en flexion latérale de chaque dent 26 lors du montage ou du fonctionnement du réacteur électrochimique.

Il est possible de prévoir des dents 26 rapprochées, ce qui permet d'utiliser le dispositif de mesure de tension 20 avec un réacteur électrochimique 2 dont les séparateurs sont très minces.

En particulier, la répartition des dents 26 sur deux bords 24A et 24B opposés de la base 24 permet d'augmenter l'espacement entre deux contacts électriques 28 adjacents d'une rangée de dents 26.

Cette disposition est avantageuse dans le cas où les cellules électrochimiques 10 sont fines ce qui limite l'écartement possible entre deux contacts électriques 28 adjacents d'une rangée de dents 26.

Par ailleurs, le fait que les dents 26 soient réparties sur deux bords 24A et 24B opposés de la base 24 confère au dispositif 20 une meilleure tenue mécanique.

Un dispositif 20 possédant une seule rangée de dents 26 (Figure 4) aura tendance à fléchir et à se rapprocher de l'empilement 4 de cellules électrochimiques 10, alors que la présence de dents 26 sur deux bords 24A et 24B opposés de la base 24 réduit cet effet de flexion.

L'invention n'est pas limitée aux exemples de réalisation et aux variantes décrites ci-dessus. D'autres exemples de réalisation et d'autres variantes sont envisageables.

Par exemple, des dents 26 peuvent avoir leurs extrémités alignées suivant un axe d'alignement oblique par rapport à la direction d'extension D (i.e. un axe d'alignement non parallèle avec la direction d'extension D et non perpendiculaire à la direction d'extension D).

En particulier il est possible de prévoir, dans une même rangée de dents 26, un premier groupe de dents 26 dont les extrémités distales 26B sont alignées suivant un premier axe d'alignement et un deuxième groupe de dents 26 dont les extrémités distales 26B sont alignées suivant un deuxième axe d'alignement distinct du premier axe d'alignement, le premier axe d'alignement étant perpendiculaire ou oblique par rapport à la direction d'extension D et le deuxième axe d'alignement étant perpendiculaire ou oblique par rapport à la direction d'extension, le première axe d'extension et le deuxième axe d'extension étant parallèles entre eux ou faisant un angle non nul entre eux.

Par ailleurs, lorsque les dents 26 sont réparties entre une première rangée 30 et une deuxième rangée 50, les dents 26 de chaque rangée 30, 50 ne sont pas nécessairement alignées suivant un axe d'alignement perpendiculaire à la direction d'extension D.

En particulier, le paragraphe situé au-dessus du précédent s'applique aux dents de chacune de la première rangée 30 et de la deuxième rangée 50.

Ainsi, dans chacune de la première rangée 30 et de la deuxième rangée 50, il est possible de prévoir un premier groupe de dents 26 dont les extrémités distales 26B sont alignées suivant un premier axe d'alignement et un deuxième groupe de dents 26 dont les extrémités distales 26B sont alignées suivant un deuxième axe d'alignement distinct du premier axe d'alignement, le premier axe d'alignement étant perpendiculaire ou oblique par rapport à la direction d'extension D et le deuxième axe d'alignement étant perpendiculaire ou oblique par rapport à la direction d'extension, le première axe d'extension et le deuxième axe d'extension étant parallèles entre eux ou faisant un angle non nul entre eux.

En outre, le support 22 peut comprend des dents 26 dont les extrémités distales 26B ne sont pas alignées suivant un axe d'alignement.

En particulier, une rangée de dents 26 du support 22 peut comprendre un groupe de dents 26 dont les extrémités distales 26B sont alignées suivant un axe d'alignement et un groupe de dents 26 dont les extrémités distales 26B ne sont pas alignées.

## Revendications

1. Dispositif de mesure de tension pour la mesure de la tension d'une pluralité de cellules électrochimiques (10) d'un réacteur électrochimique formé d'un empilement de séparateurs (6) et d'assemblages membrane-électrodes (8), chaque cellule électrochimique (10) étant formée d'un assemblage membrane-électrodes (8) intercalé entre deux séparateurs (6), le dispositif de mesure de tension comprenant un support (22) possédant une base (24) et une pluralité de dents (26) s'étendant à partir de la base (24) suivant une direction d'extension (D) commune, chaque dent (26) possédant une extrémité proximale (26A) reliée à la base (24) et une extrémité distale (26B) libre portant un contact électrique (28) prévu pour venir en contact avec un séparateur (6), le support (22) comprenant des dents (26) dont les extrémités distales (26B) sont décalées les unes par rapport aux autres suivant la direction d'extension (D).

2. Dispositif de mesure de tension selon la revendication 1, dans lequel les dents (26) incluent des dents (26) dont les extrémités distales (26B) sont alignées suivant un premier axe d'alignement (A1) et des dents (26) dont les extrémités distales (26B) sont décalées par rapport au premier axe d'alignement (A1).

3. Dispositif de mesure de tension selon la revendication 2, dans lequel le premier axe d'alignement (A1) est perpendiculaire à la direction d'extension (D).

4. Dispositif de mesure de tension selon la revendication 2 ou 3, dans lequel le support (20) comprend une rangée (30) de dents (26) dans laquelle alternent les dents (26) dont les extrémités distales (26B) sont alignées suivant un premier axe d'alignement (A1) et des dents (26) dont les extrémités distales (26B) sont décalées par rapport au premier axe d'alignement (A1).

5. Dispositif de mesure de tension selon l'une quelconque des revendications 2 à 4, dans lequel les dents (26) dont les extrémités distales sont décalées par rapport au premier axe d'alignement (A1) ont leurs extrémités distales alignées suivant un deuxième axe d'alignement (A1) distinct du premier axe d'alignement (A2).

6. Dispositif de mesure de tension selon la revendication 5, dans lequel le deuxième axe d'alignement (A2) est perpendiculaire à la direction d'extension (D) et/ou parallèle au premier axe d'alignement (A1).

7. Dispositif de mesure de tension selon l'une quelconque des revendications précédentes, dans lequel les dents (26) incluent des dents (26) de différentes longueurs.

8. Dispositif de mesure de tension selon la revendication 7, comprenant des dents (26) présentant une première longueur (L1) et des dents (26) présentant une deuxième longueur (L2), la première longueur (L1) étant strictement supérieure à la deuxième longueur (L2).

9. Dispositif de mesure de tension selon la revendication 8, dans lequel le support (20) comprend une rangée (30) de dents (26) dans laquelle alternent des dents (26) présentant la première longueur (L1) et des dents (26) présentant la deuxième longueur (L2).

10. Dispositif de mesure de tension selon l'une quelconque des revendications précédentes, dans lequel les dents (26) sont réparties entre une première rangée (50) de dents (26) et une deuxième rangée (52) de dents (26) situées de part et d'autre de la base (24).

11. Dispositif de mesure de tension selon l'une quelconque des revendications précédentes, dans lequel au moins une dent (34) ou chaque dent (34) présente une largeur progressivement décroissante puis croissante depuis l'extrémité proximale (26A) de la dent (34) vers l'extrémité distale de la dent (34).

12. Dispositif de mesure de tension selon l'une quelconque des revendications précédentes, dans lequel le support (22) comprend une rangée (30) de dents (26) ayant une première dent portant un contact électrique supplémentaire (40) configuré pour venir en contact avec un séparateur adjacent à celui avec lequel le contact électrique (28) porté par cette première dent (26) vient en contact.

13. Dispositif de mesure de tension selon l'une quelconque des revendications précédentes, comprenant une unité électronique de mesure (44), chaque contact électrique (28) étant relié à l'unité électronique de mesure (44), l'unité électronique de mesure (44) étant configurée pour générer un signal de mesure de tension respectif pour chaque cellule électrochimique (10) dont la tension est prise grâce au dispositif de mesure de tension, à partir de signaux électriques fournis par les contacts électriques (28) et/ou pour conditionner les signaux électriques fournis par les contacts électriques (28) et/ou des signaux de mesure de tension générés par l'unité électronique de mesure (44), pour leur transmission à un appareil électronique.

14. Dispositif de mesure de tension selon l'une quelconque des revendications précédentes, comprenant un connecteur (46) pour connecter le dispositif de mesure de tension à un appareil électronique.

15. Système électrochimique comprenant un réacteur électrochimique (2) formé d'un empilement (4) de séparateurs (6) et d'assemblages membrane-électrodes (8) définissant des cellules électrochimiques (10), chaque cellule électrochimique (10) étant formée d'un assemblage membrane-électrodes (8) intercalé entre deux séparateurs (6), et au moins un dispositif de mesure de tension (20) selon l'une quelconque des revendications précédentes.
